# EUROPEAN PATENT APPLICATION

(11) **EP 4 319 482 A1**
(43) Date of publication of application: **07.02.2024**
(21) Application number: 22779521.8
(22) Date of filing: 04.02.2022
(51) Int. Cl.: H05B 3/10, H05B 3/72, H01L 21/683

(54) **PLACEMENT PANEL AND PLACEMENT STRUCTURE**

(30) Priority: 30.03.2021 JP 2021058621
(71) Applicant: NHK Spring Co., Ltd., Yokohama-shi, Kanagawa 236-0004 (JP)
(72) Inventor: KIDA, Naoya, Yokohama-shi, Kanagawa 236-0004 (JP); FUTAKUTIYA, Jun, Yokohama-shi, Kanagawa 236-0004 (JP); FUJINO, Daisuke, Yokohama-shi, Kanagawa 236-0004 (JP); AIKAWA, Naoya, Yokohama-shi, Kanagawa 236-0004 (JP); WADA, Keiko, Yokohama-shi, Kanagawa 236-0004 (JP); NAKAJIMA, Aya, Yokohama-shi, Kanagawa 236-0004 (JP)
(74) Representative: Hoffmann Eitle
(86) International application number: PCT/JP2022/004526
(87) International publication number: WO 2022/209292

(57) **Abstract**

A placement board according to the present invention includes: a main body unit is configured to form a flow channel for circulation of a medium for heat exchange and place a workpiece thereon, the main body unit being made of a metallic material; and a heater provided in an outer edge region of the main body unit. In a state where the heater has been driven and the medium has been caused to circulate through the flow channel, a temperature difference between the outer edge region and an inner region of the main body unit at a surface of the main body unit where the workpiece is placed is 20°C or more.

## Description

### Field

The present invention relates to placement boards and placement structures where workpieces are placed. Background

Semiconductor manufacturing apparatuses for manufacture of semiconductors used for industrial purposes and automotive purposes and liquid crystal manufacturing apparatuses for manufacture of liquid crystal displays conventionally have placement boards that hold workpieces, such as wafers, and that have a heating function to make temperature distributions in the workpieces uniform (see, for example, Patent Literature 1). A ceramic plate provided with a heater element in each of an inner peripheral region and an outer peripheral region of the ceramic plate is disclosed in Patent Literature 1. In terms of freedom of arrangement of heaters, contamination, and heat resistance, for example, ceramics have been generally used conventionally. The ceramic plate can serve as a placement board having a temperature gradient profile by control of each of the heater element in the inner peripheral region and the heater element in the outer peripheral region, the temperature gradient profile being a profile in which the outer peripheral region and the inner peripheral region have temperatures different from each other, for example, in which temperature increases toward the outer peripheral region. The ceramic plate described in Patent Literature 1 can be caused to have a temperature gradient such that the temperature difference between the outer peripheral region and the inner peripheral region becomes about 10°C.

### Citation List

### Patent Literature

Patent Literature 1: Japanese National Publication of International Patent Application No. 2018/030433

### Summary

### Technical Problem

There is a demand for a larger temperature difference between the outer peripheral region and the inner peripheral region of the placement board described above. However, the placement board described in Patent Literature 1 is made of a ceramic material and the placement board may be damaged when the temperature difference between the outer peripheral region and the inner peripheral region is caused to be 10°C or more.

The present invention has been made in view of the above and an object thereof is to provide a placement board and a placement structure that enable increase in temperature difference between an outer peripheral region and an inner peripheral region thereof.

### Solution to Problem

To solve the above-described problem and achieve the object, a placement board according to the present invention includes: a main body unit configured to form a flow channel for circulation of a medium for heat exchange and place a workpiece thereon, the main body unit being made of a metallic material; and a heater provided in an outer edge region of the main body unit, wherein a temperature difference between the outer edge region and an inner region of the main body unit at a surface of the main body unit where the workpiece is placed is 20°C or more in a state where the medium has been caused to circulate through the flow channel.

Moreover, the above-described placement board according to the present invention, further includes a heat insulation groove formed in the main body unit, the heat insulation groove surrounding the flow channel.

Moreover, in the above-described placement board according to the present invention, the heater is provided closer to the outer edge of the main body unit than the heat insulation groove.

Moreover, in the above-described placement board according to the present invention, the heater is provided closer to the inner region of the main body unit than the heat insulation groove.

Moreover, in the above-described placement board according to the present invention, the main body unit includes plural members layered over one another, and a member of the plural members includes the flow channel formed therein and the heater provided therein, the member having the surface where the workpiece is placed.

Moreover, a placement structure according to the present invention includes: a workpiece; a placement board including a main body unit configured to form a flow channel for circulation of a medium for heat exchange and place the workpiece thereon, the main body unit being made of a metallic material; and a heater provided in an outer edge region of the main body unit, wherein in a state where the heater has been driven and the medium has been caused to circulate through the flow channel, a temperature difference between the outer edge region and an inner region of the main body unit at a surface of the main body unit where the workpiece is placed is 20°C or more, and a temperature difference between a lowest temperature and a highest temperature of the workpiece in a state where the workpiece has been placed on the placement board is 20°C or more.

### Advantageous Effects of Invention

The present invention has an effect of enabling increase in temperature difference between an outer peripheral region and an inner peripheral region, of a placement board and a workpiece placed on the placement board.

### Brief Description of Drawings

FIG. 1 is a plan view and a partial sectional view of a configuration of a placement board according to an embodiment of the present invention.
FIG. 2 is a diagram for description of an example of a temperature distribution in a plate unit upon use of the placement board according to the embodiment of the present invention.
FIG. 3 is a sectional view of a configuration of main parts of a placement board according to a first modified example of the embodiment of the present invention.
FIG. 4 is a partial sectional view of a configuration of a placement board according to a second modified example of the embodiment of the present invention.

### Description of Embodiments

An embodiment of the present invention will hereinafter be described in detail, together with the drawings. The present invention is not limited by the following embodiment. Furthermore, the drawings referred to in the description hereinafter illustrate shapes, sizes, and positional relations merely schematically so as to enable subject matter of the present invention to be understood. That is, the present invention is not limited just to the shapes, sizes, and positional relations exemplified by the drawings.

### Embodiment

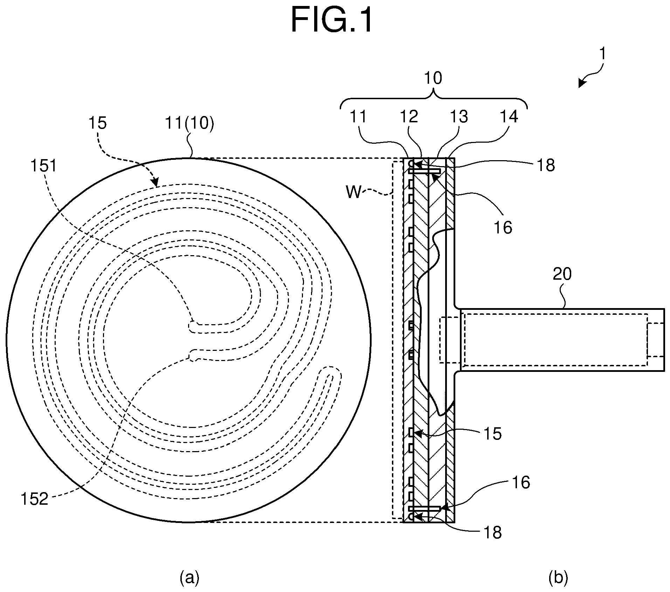

FIG. 1 is a plan view and a partial sectional view of a configuration of a placement board according to an embodiment of the present invention. In FIG. 1, (a) is a plan view of a surface (hereinafter, referred to as a "workpiece placement surface") of a placement board 1, the surface being where a workpiece (a workpiece W illustrated by (b) in FIG. 1) is placed, the plan view being viewed from a direction orthogonal to the surface. In FIG. 1, (b) is a partial sectional view viewed from a direction parallel to the workpiece placement surface. The placement board 1 is used for maintaining the temperature of the workpiece and making the temperature distribution of the workpiece uniform, in, for example, a heat treatment process, such as a thin-film deposition process or an etching process, in manufacture of semiconductors. The workpiece is made of a semiconducting compound, such as silicon, silicon carbide, sapphire, gallium phosphide (GaP), gallium arsenide (GaAs), indium phosphide (InP), or gallium nitride (GaN). A configuration having the workpiece W placed on the placement board 1 (see (b) in FIG. 1) corresponds to a placement structure.

The placement board 1 includes a plate unit 10 that is disk-shaped and a connection unit 20 connected to a surface of the plate unit 10, the surface being opposite to the work placement surface.

The plate unit 10 is made of a metallic material. The metallic material may be a heavy metal, a noble metal, or an alloy of a heavy or noble metal. For example, the metallic material may be a metal or alloy, such as aluminum, an aluminum alloy, titanium, a titanium alloy, iron, an iron-based alloy, copper, a copper alloy, nickel, a nickel-based alloy, molybdenum, tungsten, or gold. The iron-based alloy may be, for example, stainless steel, Kovar, or 42 Alloy. The nickel-based alloy may be, for example, Inconel or Hastelloy. The metallic material is preferably a material high in thermal conductivity. The plate unit 10 has four disk members (a first disk member 11 to a fourth disk member 14) layered over one another. Specifically, in order from the direction of the first disk member 11, the second disk member 12 and the third disk member 13 are positioned between the first disk member 11 where the workpiece is placed and the fourth disk member 14 where the connection unit 20 is connected.

The plate unit 10 has, formed therein: a flow channel through which a medium that prompts heat exchange flows; and a heat insulation groove 16. Specifically, the flow channel 15 is formed by a groove being covered with a surface of the second disk member 12, the groove having a bottom and being formed on a surface of the first disk member 11, the surface being opposite to the workpiece placement surface of the first disk member 11 (having the workpiece placement surface), the workpiece placement surface being where the workpiece is placed. Circulation of the medium through the flow channel 15 causes heat exchange at the workpiece placement surface of the plate unit 10. The flow channel 15 may be formed by a pipe or tube being sandwiched between members.

The medium that circulates through the flow channel 15 may be, for example, a liquid, such as water, or a gas. For example, the medium is introduced into the flow channel 15 from a first opening 151 and released outside the first disk member 11 from a second opening 152 after flowing over a wide range of the first disk member 11 along the flow channel. The circulation of the medium causes heat exchange between: the medium; and the plate unit 10 and workpiece.

The heat insulation groove 16 is formed by communication of: grooves formed in the first disk member 11 and third disk member 13, the grooves each having a bottom; and a through hole formed in the second disk member 12, with each other. The heat insulation groove 16 is formed to surround the flow channel 15. An example in which the heat insulation groove 16 forms a closed space and the heat insulation groove 16 is vacuum inside will be described with respect to this embodiment, but the heat insulation groove 16 may be not vacuum, part of the heat insulation groove 16 may communicate with the outside and air may circulate through the heat insulation groove 16, or the inside of the heat insulation groove 16 may be filled with, for example, a solvent or resin high in thermostability.

Furthermore, the plate unit 10 includes a heater 18 provided more radially outward (outside) than the heat insulation groove 16. The heater 18 is driven under control by a control device not illustrated in the drawings. The heater 18 is configured by use of, for example, a heating wire, and is provided along the periphery of the first disk member 11. Upon installation of the placement board 1 in, for example, a semiconductor control apparatus, the heater 18 is electrically connected to a control device included in that semiconductor manufacturing apparatus. For example, the heater 18 is installed in the first disk member 11 by being covered with a sprayed film after being buried in a groove in the first disk member 11.

The connection unit 20 has, formed therein, a flow channel (not illustrated in the drawings) in which the medium circulates. Specifically, via the flow channel, the connection unit 20 sends the medium to the first opening 151 and receives the medium released from the second opening 152. The connection unit 20 is connected to a supply source of the medium, at an end portion of the connection unit 20, the end portion being at an opposite end of the connection unit 20, the opposite end being opposite to an end of the connection unit 20, the end being an end connected to the plate unit 10. The supply source is, for example, a pump and a tank that holds the medium, or a water pipe.

Temperature of the placement board 1 is adjusted by the plate unit 10 being heated by the heater 18 and heat absorption by the medium circulating through the flow channel 15. In this adjustment, the heat insulation groove 16 reduces conduction of heat from the heater 18 radially inward and any thermal stress generated is relieved by escaping into the heat insulation groove 16.

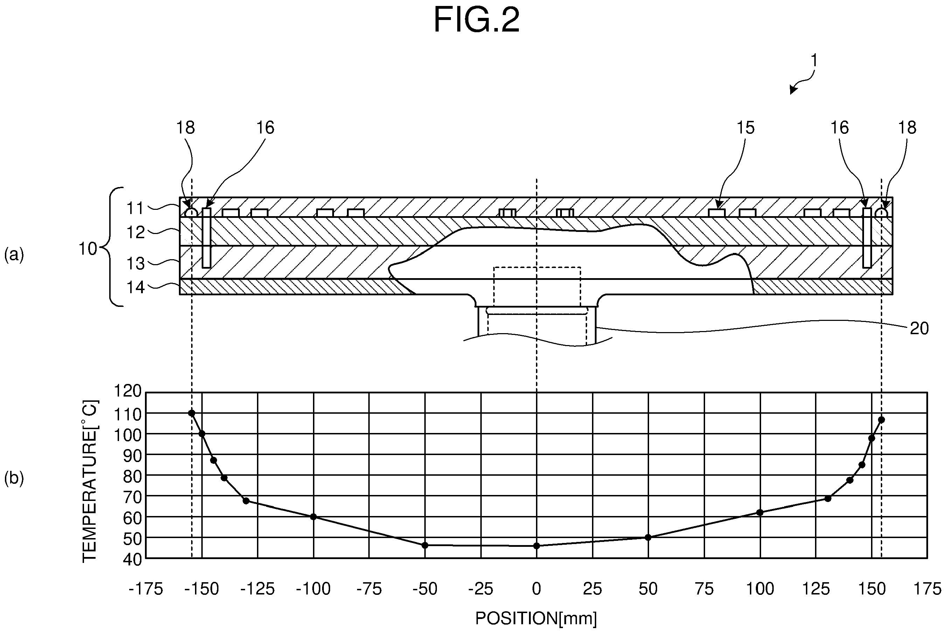

FIG. 2 is a diagram for description of an example of a temperature distribution in a plate unit upon use of the placement board according to the embodiment of the present invention. In FIG. 2, (a) illustrates a partial sectional view of the placement board 1. In FIG. 2, (b) illustrates a graph having surface temperatures plotted, the surface temperatures being temperatures at corresponding positions of the placement board 1 illustrated by (a) in FIG. 2. A position passing through the center of the placement board 1 is referred to as zero, a position on one side of the center is referred to as a position in a positive direction, and a position on the opposite side of the center is referred to as a position in a negative direction. FIG. 2 is results of measurement performed with the heater 18 set at a temperature of 110°C. Furthermore, in the placement board 1 illustrated by (a) in FIG. 2, the heater 18 is positioned at positions, 155 mm and -155 mm and the heat insulation groove 16 is positioned near 150 mm and near -150 mm.

As can be seen by (b) in FIG. 2, there is a temperature difference between an outer peripheral region and an inner peripheral region of the plate unit 10. Specifically, there is a temperature difference of about 63°C between: the positions of 155 mm and -155 mm (110°C) at the highest temperature; and the zero position (about 47°C) at the lowest temperature.

Upon heat treatment in a semiconductor manufacturing process, a workpiece placed on a plate (corresponding to the placement board 1) is desired to have a uniform temperature distribution. An outer peripheral region tends to decrease in temperature more than an inner peripheral region and an outer peripheral region of a workpiece may thus decrease in temperature on a conventional plate. In particular, upon thin-film deposition on a workpiece, for example, in implementation of a chemical vapor deposition (CVD) or atomic layer deposition (ALD) process, application of plasma causes local increase in temperature of a central portion of the workpiece and thus increase in temperature difference between the central portion and an outer peripheral region of the workpiece. Therefore, providing a large temperature difference at a workpiece placement surface like in the placement board 1 enables temperature of a workpiece to be maintained uniform even in a case where a central portion of the workpiece increases in temperature, while minimizing decrease in temperature of an outer peripheral region of the workpiece.

The temperature difference between the inner peripheral region and the outer peripheral region may also be adjusted according to the process.

In this embodiment, forming the placement board 1 by use of a metallic material achieves a temperature difference larger than a temperature difference at which cracks are generated in ceramics. The temperature difference at the workpiece placement surface is, for example 20°C or more and 100°C or less, and in a case where a higher temperature difference is demanded, the temperature difference is 60°C or more and 100°C or less. This temperature range is set on the basis of leakage of electricity and transformation points of the liquid. The temperature distribution in a workpiece placed on the placement board 1 then has a profile equivalent to the temperature profile of the placement board 1 and, for example, the difference between the lowest temperature and the highest temperature of the workpiece becomes 20°C or more and 100°C or less.

As described above, the placement board 1 according to the embodiment has: the flow channel 15 formed in the plate unit 10 made of a metallic material; and the heater 18 provided in the outer peripheral region of the plate unit 10, the flow channel 15 being for circulation of the medium that prompts heat exchange. Implementing heating and heat exchange by means of the flow channel 15 and the heater 18 in this embodiment enables the temperature difference between the outer peripheral region and the inner peripheral region to be made larger than that in a ceramic plate.

Furthermore, the heat insulation groove 16 in this embodiment minimizes conduction of heat from the heater 18 to the inner peripheral region, increase in thermal resistance due to obstruction of a solid portion of the plate unit 10 (decrease in sectional area) decreases heat flow, the increase corresponding to the space in the heat insulation groove 16, and the heat insulation groove 16 thus serves as a thermal choke.

### First Modified Example

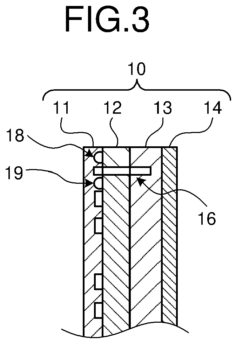

A first modified example of the embodiment described above will be described next by reference to FIG. 3. FIG. 3 is a sectional view of a configuration of main parts of a placement board according to a first modified example of the embodiment of the present invention. The placement board according to the first modified example further includes a heater 19, compared with the placement board 1 described above. Components other than the heater 19 are the same as those of the placement board 1 described above and description thereof will thus be omitted.

The heater 19 (an inner heater) is provided in an outer peripheral region of the placement board and more radially inward (inside) than a heat insulation groove 16. That is, the heater 19 is provided on an opposite side of the heat insulation groove 16, the opposite side being opposite to one side of the heat insulation groove 16, the one side being where a heater 18 (outer heater) is provided.

A plate unit 10 is able to be heated in a region outward and a region inward from the heat insulation groove 16 in the placement board according to the first modified example. In this heating, adjusting output of the heaters 18 and 19 individually enables control of the temperature distribution of the plate unit 10.

As described above, similarly to the embodiment, the placement board according to the first modified example has a flow channel 15 formed in the plate unit 10 made of a metallic material, the flow channel 15 being for circulation of a medium that prompts heat exchange, has the heater 18 provided in an outer peripheral region of the plate unit 10, and thus enables increase in temperature difference between the outer peripheral region and an inner peripheral region as compared with a ceramic plate.

Furthermore, because heaters are provided on both sides of the heat insulation groove 16 in this first modified example, the temperature distribution is able to be adjusted more finely.

### Second Modified Example

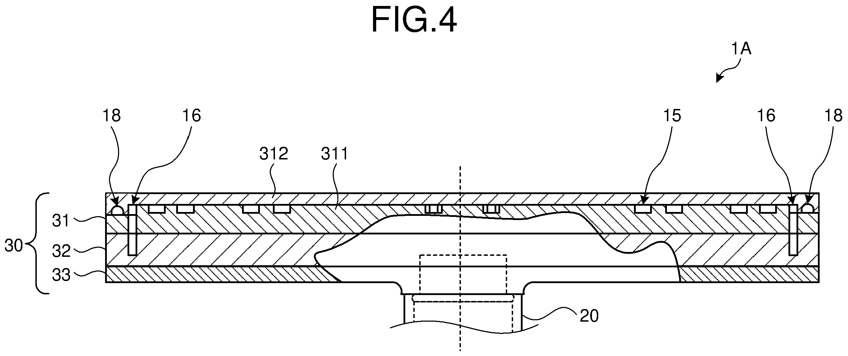

A second modified example of the embodiment described above will be described next by reference to FIG. 4. FIG. 4 is a partial sectional view of a configuration of a placement board according to a second modified example of the embodiment of the present invention. A placement board 1A according to the second modified example includes a plate unit 30 instead of the plate unit 10 in the placement board 1 described above. Components other than the plate unit 30 are the same as those of the placement board 1 described above and description thereof will thus be omitted.

The plate unit 30 is made of a metallic material. The metallic material may be a metal or alloy similar to that of the plate unit 10. The plate unit 30 has three disk members (a first disk member 31 to a third disk member 33) layered over one another. Specifically, the second disk member 32 is positioned between the first disk member 31 where a workpiece is placed and the third disk member 33 where a connection unit 20 is connected.

The plate unit 30 has, formed therein: a flow channel 15 through which a medium that prompts heat exchange flows; and a heat insulation groove 16. Furthermore, the plate unit 30 includes a heater 18 provided more radially outward (outside) than the heat insulation groove 16.

The first disk member 31 has a main body portion 311 and a lid portion 312. The lid portion 312 is formed of, for example, aluminum or an aluminum alloy, and may be formed of a material that is the same as that of the main body portion 311 or the second disk member 32 and third disk member 33, or may be formed of a material different from that of the main body portion 311 or the second disk member 32 and third disk member 33.

The flow channel 15 is formed by a groove being covered with the lid portion 312, the groove having been formed in the main body portion 311. Furthermore, the heat insulation groove 16 is formed by a groove being covered with the lid portion 312, the groove having been formed in the main body portion 311 and the second disk member 32.

Furthermore, the heater 18 is fixed to the first disk member 31 by being covered with the lid portion 312 in a state of being arranged on the main body portion 311.

As described above, similarly to the embodiment, the placement board according to the second modified example has the flow channel 15 formed in the plate unit 30 made of a metallic material, the flow channel 15 being for circulation of a medium that prompts heat exchange, has the heater 18 provided in an outer peripheral region of the plate unit 30, and thus enables increase in temperature difference between the outer peripheral region and an inner peripheral region as compared with a ceramic plate.

Furthermore, the second modified example has the lid portion 312 formed of a material high in thermal conductivity and thereby enables efficient temperature adjustment.

With respect to the above described embodiment and modified examples, an example in which the heater 18 or 19 respectively provided outward or inward from the heat insulation groove 16 is provided singly in a cross section has been described, but a configuration in which plural heaters are provided along the radius in each of regions outward and inward from the heat insulation groove 16 or a configuration in which plural heaters are provided along a thickness of the plate may be adopted instead. The numbers of the heaters 18 and 19 in a cross section may be the same or different from each other. For example, a plurality of the heaters 18 may be provided outward, a plurality of the heaters 19 may be provided inward, or a plurality of the heaters 18 and a plurality of the heaters 19 may be respectively provided outward and inward.

Furthermore, with respect to the above described embodiment and modified examples, an example in which a target member is cooled has been described, but a heat exchange plate may prompt heat exchange for heating a target member. In a case where a heat exchange plate heats a target member, a medium, such as warm water, or a gas that provides heat, such as warm air, circulates through the flow channel 15 in the heat exchange plate.

Furthermore, with respect to the above described embodiment and modified examples, an example in which the heat insulation groove 16 is included has been described, but any configuration without the heat insulation groove 16 and enabling the temperature distribution to be made uniform may be adopted instead. Furthermore, in the modified examples, a configuration with just the heater 19 and without the heater 18 may be adopted instead.

Furthermore, with respect to the above described embodiment and modified examples, an example in which the plate unit 10 has four disk members layered over one another has been described, but the number of the disk members is not limited to four. For example, the plate unit 10 may have two members layered over each other, or a single member may have the flow channel 15 and heat insulation groove 16 formed therein and the heaters 18 and 19 provided therein.

Furthermore, with respect to the above described embodiment and modified examples, an example in which the plate unit 10 is disk-shaped has been described, but without being limited to being disk-shaped, for example, the plate unit 10 may be prism-shaped.

Furthermore, with respect to the above described embodiment and modified examples, an example in which the outer peripheral region is high in temperature and the inner (inner peripheral) region is low in temperature has been described, but the opposite may be true for this temperature difference. In that case also, the outer peripheral region and the inner region have a temperature difference of 20°C or more.

The present invention may thus include various embodiments not described herein, and various design changes, for example, may be made without departing from the technical ideas determined by the claims.

### Industrial Applicability

As described above, a placement board and a placement structure according to the present invention are suitable for increasing temperature difference between an outer peripheral region and an inner peripheral region thereof.

### Reference Signs List

1, 1A PLACEMENT BOARD
10, 30 PLATE UNIT
11, 31 FIRST DISK MEMBER
12, 32 SECOND DISK MEMBER
13, 33 THIRD DISK MEMBER
14 FOURTH DISK MEMBER
15 FLOW CHANNEL
16 HEAT INSULATION GROOVE
18, 19 HEATER
20 CONNECTION UNIT
311 MAIN BODY PORTION
312 LID PORTION

## Claims

1. A placement board comprising:
a main body unit configured to form a flow channel for circulation of a medium for heat exchange and place a workpiece thereon, the main body unit being made of a metallic material; and
a heater provided in an outer edge region of the main body unit, wherein
a temperature difference between the outer edge region and an inner region of the main body unit at a surface of the main body unit where the workpiece is placed is 20°C or more in a state where the medium has been caused to circulate through the flow channel.

2. The placement board according to claim 1, further comprising a heat insulation groove formed in the main body unit, the heat insulation groove surrounding the flow channel.

3. The placement board according to claim 2, wherein the heater is provided closer to the outer edge of the main body unit than the heat insulation groove.

4. The placement board according to claim 2 or 3, wherein the heater is provided closer to the inner region of the main body unit than the heat insulation groove.

5. The placement board according to any one of claims 1 to 4, wherein
the main body unit includes plural members layered over one another, and
a member of the plural members includes the flow channel formed therein and the heater provided therein, the member having the surface where the workpiece is placed.

6. A placement structure comprising:
a workpiece;
a placement board including a main body unit configured to form a flow channel for circulation of a medium for heat exchange and place the workpiece thereon, the main body unit being made of a metallic material; and
a heater provided in an outer edge region of the main body unit, wherein
in a state where the heater has been driven and the medium has been caused to circulate through the flow channel, a temperature difference between the outer edge region and an inner region of the main body unit at a surface of the main body unit where the workpiece is placed is 20°C or more, and
a temperature difference between a lowest temperature and a highest temperature of the workpiece in a state where the workpiece has been placed on the placement board is 20°C or more.
